# EUROPEAN PATENT APPLICATION

(11) **EP 0 930 643 A2**
(43) Date of publication of application: **21.07.1999**
(21) Application number: 99101017.4
(22) Date of filing: 19.01.1999
(51) Int. Cl.: H01L 21/223, H01L 21/00

(54) **Method for formation of a doped region in a semiconductor substrate and apparatus therefor**

(30) Priority: 20.01.1998 JP 856398
(71) Applicant: Semiconductor Process Laboratory Co., Ltd., Minato-ku, Tokyo 108-0075 (JP)
(72) Inventor: Satoh, Noritada, Kanagawa 238 (JP); Matsui, Bunya, Kawasaki-shi, Kanagawa 216 (JP)
(74) Representative: Schwabe - Sandmair - Marx

(57) **Abstract**

The invention relates to a formation method of impurity region in a semiconductor layer for introducing a dopant impurity as a donor or an acceptor. The formation method comprises the steps of; mixing a impurity gas with a gas containing any one of H₂ and an inert gas, electrically discharging the mixed gas, diffusing impurities adhered to the surface of a semiconductor layer 12 to the semiconductor layer 12, by introducing the discharged impurity gas to the surface of the semiconductor layer, at the same time, by accelerating ions of the gas containing any one of the H₂ and inert gases to irradiate the surface of the semiconductor layer, and by raising temperature of the surface of the semiconductor layer, and activating electrically the same.

## Description

### BACKGROUND OF THE INVENTION

### 1. Field of the Invention

The present invention relates to a method for formation of impurity region in a semiconductor layer to introduce a dopant impurity as a donor or an acceptor, and to an apparatus for introducing an impurity to a semiconductor layer.

### 2. Description of the Prior Art

Methods for formation of impurity region in a semiconductor substrate include heat diffusion, epitaxial growth, ion implantation, and plasma doping.

These methods require heating at a high temperature (approximate 800 - 1300 °C) for diffusion of impurities and electric activation of the diffused impurities.

However, such heating of the semiconductor substrate at a high temperature cause problems such as a crystal defect in the semiconductor substrate, a penetration of atoms other than a dopant impurity to the semiconductor substrate, or decrease in life time of a minority carrier by the former two reasons.

In addition, there are problems: the depth of the impurity region is as deep as some micrometers or more; the concentration of the surface of the impurity region cannot be controlled to make a proper concentration of 10²² atms/ cm³ or lower.

### SUMMARY OF THE INVENTION

It is the purpose of the invention to provide a method for formation of impurity region in a semiconductor layer, wherein the impurity region can be formed without heating of the semiconductor layer at a high temperature so that a crystal defect in the semiconductor layer and the penetration of a substance other than a dopant impurity to the semiconductor layer can be prevented, and the impurity concentration at the surface of the impurity region can be controlled uniformly to a proper concentration of 10²² atms/cm³ or lower, and the depth of the impurity region can be controlled to 1 µm or lower.

According to the invention, an impurity gas is mixed with a gas containing any one of H₂ and inert gases, and the mixed gas is electrically discharged.

Electric discharge of the impurity gas generates ions and radicals of the impurity gas. These ions and radicals attach to the surface of a semiconductor layer.

At this time, in company with discharging of the impurity gas, the gas containing any one of H₂ and inert gases is also almost simultaneously discharged to dissociate to ions. Thus the ions of the gas containing any one of H₂ and inert gases are accelerated to collide to the semiconductor layer resulting in the rise of temperature of the site collided. Therefore, thermal energy is given to the impurities on the surface of the semiconductor layer, so that these impurities are diffused into the semiconductor layer, and the impurities are electrically activated. Namely, the reached impurities can be activated simultaneously with the introduction thereof to the semiconductor layer.

These steps allow the impurity region to be formed on the semiconductor layer.

Further, according to the method, of the present invention, for formation of impurity region in a semiconductor layer, lack of heating the semiconductor layer at a high temperature can reduce thermal stress to the semiconductor layer and crystal defect. The deep penetration of impurities to the semiconductor layer can be also prevented.

Furthermore the adjustment of the mixing ratio of the impurity gas with the gas containing any one of H₂ and inert gases allows adjusting the quantity of impurity activated electrically.

### BRIEF DESCRIPTION OF THE DRAWINGS

Fig. 1 is a block diagram illustrating an apparatus, according to the embodiment of the present invention, for introducing an impurity to a semiconductor layer.

Fig. 2 is a view showing relationship between the depth from the surface of silicon wafer and boron concentration.

Fig. 3A and Fig. 3B are views showing sheet resistance on the surface of silicon wafer.

### DESCRIPTION OF THE PREFERRED EMBODIMENT

Below is the description of the preferred embodiment according to the invention in conjunction with drawings adhered.

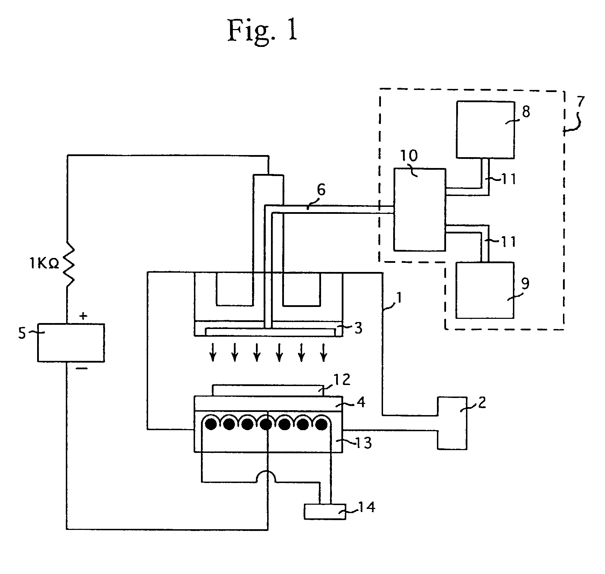

Fig. 1 is a block diagram illustrating an apparatus for introducing an impurity to a semiconductor substrate, of mode for carrying out the invention.

An internal surface of a vacuum chamber 1 is covered with an insulator of quartz glass or the like and connected to exhaust apparatus 2. The exhaust apparatus 2 regulates a pressure in the vacuum chamber 1.

The interior of the vacuum chamber 1 is provided with electrodes 3 and 4 opposed to each other. These electrodes 3 and 4 are connected to a DC power source 5 used for generating plasma. These components constitute an electric discharging means. Plasma is generated between the electrodes 3 and 4 by applying a voltage from the DC power source 5 used for generating plasma.

The DC power source 5 has a circuit for inverting the polarity of the voltage and can supply a pulsed inverse voltage to the electrodes 3 and 4 in a given time intervals. The pulsed inverse voltage may be of rectangular waves or triangular waves.

The surface of the electrode 3 opposing to the electrode 4 has a plurality of outlet pores for dopant impurity gas, which are opened with a diameter of approximate 1 mm and evenly distributed over the surface. The set of outlet pores of the electrode 3 is connected to a gas supply apparatus 7 via an insulated pipe 6.

The gas supply apparatus 7 comprises a dopant impurity gas chamber 8, inert gas chamber 9, and regulation means 10, etc. The dopant impurity gas chamber 8 and the inert gas chamber 9 are respectively connected to the regulation means 10 via a pipe 11.

The regulation means 10 comprises a mass flow and a pressure gauge, etc., and regulates mixing ratio and flow rate of a gas mixed with dopant impurity gas and inert gas respectively carried from the dopant impurity gas chamber 8 and the inert gas chamber 9.

Subsequently, the mixed gas is carried through the pipe 6 to be discharged from the outlet pores of the electrode 3 into the vacuum chamber 1.

A semiconductor substrate 12 is placed on the electrode 4. On the other hand, a heater 13 for heating the semiconductor substrate is located on the bottom of the electrode 4. The heater 13 is connected to a power source 14 to heat the semiconductor substrate 12.

Next, the following is a description of a method for formation of impurity region on the semiconductor substrate 12 according to this embodiment.

The semiconductor substrate 12 is placed on the electrode 4. Subsequently, the interior of the vacuum chamber 1 is exhausted by the exhaust apparatus 2 to reduce a pressure to approximate 1.33 x 10⁻² Pa.

Then, dopant impurity gas for use and inert gas are respectively carried from the dopant impurity gas chamber 8 and the inert gas chamber 9 to the regulation means 10.

The dopant impurity gas is exemplified by boron, phosphorus, aluminum, arsenic, gallium or the like, hydrogen compounds containing the element thereof, halogenated compounds containing the element thereof, or organic metals containing the element thereof. The dopant impurity gas generates electrons and holes (carriers) in a semiconductor.

For example, there are diborane (B₂H₆) and boron trifluoride that contain boron. Besides, there are phosphorus pentafluoride and phosphine gases that contain phosphorus. Further, there are arsine containing arsenic and trimethylgallium containing gallium. Furthermore, there is trimethylaluminum containing aluminum.

On the other hand, Ar or N₂ exemplifies inert gas used for this purpose. In addition, H₂ can be used.

The regulation means 10 regulates the mixing ratio and flow rate of the mixing gas composed of dopant impurity gas and inert gas carried from chambers to send to the vacuum chamber 1. As a result, the pressure of the interior of the vacuum chamber 1 are regulated to be a range of 1.33 x 10 - 1.33 x 10³ Pa.

The semiconductor substrate 12 is heated at approximate 100 °C. For this purpose, the semiconductor substrate 12 may be previously heated.

Following this step, a direct current with a given voltage is applied between the electrodes 3 and the 4 to allow glow discharge.

Dopant impurity gas between the electrodes 3 and 4 is dissociated by discharge by the direct current voltage applied between the electrodes 3 and 4 resulting to generate ions and radicals. These ions and radicals are impelled to the surface of the semiconductor substrate 12 by the electric field and attached thereto.

At this time, inert gas is almost simultaneously dissociated by discharge to generate ions, and then the ions of inert gas particles are accelerated by the electric field generated between the electrodes 3 and 4 to collide to the semiconductor substrate 12 and raise locally the temperature of the collision position. The impurity particles obtain a thermal energy due to the raised temperature to be activated. With this, the impurity particles are introduced into the semiconductor substrate 12 and electrically activated until the concentration of the exterior and interior of the semiconductor substrate reaches an equilibrated condition.

By these steps, an impurity region having a specific conductivity and type thereof is formed in the surface layer of the semiconductor substrate 12.

The use of direct current voltage in the embodiment is based on the following reasons. Using alternating current possibly causes that the occurrence of dissociation by discharge does not allow to ignore a reaction to the inner wall of the vacuum chamber 1 and an element constituting the vacuum chamber 1 may be contained in the given dopant impurity. However, an alternating current method can be selectively applied depending on a kind of the material of the vacuum chamber 1.

In the use of a direct current voltage charge-up phenomenon probably occurs. For example, it is the case of introducing dopant impurities into the semiconductor substrate 12 through the window which is formed on a SiO₂. In this case, positive ions are accumulated on the surface of the SiO₂ film by electric discharge to cause a dielectric breakdown of the SiO₂ film by high electric field applied to the SiO₂ film. It results in damage of the surface of the semiconductor substrate 12.

A low pressure of reacting gas in electric discharge as shown in this embodiment allows discharge of positive ions accumulated on the SiO₂ film through reacting gas. Therefore, the charge-up phenomenon aforementioned difficultly occurs. However, the use of a very thin SiO₂ film or photoresist film is not preferable for preparing a device, because the SiO₂ film easily comes to the dielectric breakdown. When it takes 1 - 2 seconds to come to dielectric breakdown, the polarity of an applied direct current voltage is changed at least once every 1 - 2 seconds. Accordingly, positive ions are neutralized, so that the charge-up phenomenon is reduced and finally the problem is solved.

In addition, the heating temperature for the semiconductor substrate 12 in the embodiment is low as approximate 100 °C.

Therefore, thermal stress to the semiconductor substrate 12 is reduced, so that crystal defect, etc. can be reduced. Further, deeper diffusion of dopant impurity into the semiconductor substrate 12 can be prevented.

In general, the discharge allows discharge of particles other than those of dopant impurity and inert gas contained in the vacuum chamber 1. However, a lower temperature for heating the semiconductor substrate 12 can prevent penetration of those discharged particles into the semiconductor substrate.

Further, in this embodiment the use of the gas mixed with dopant impurity gas and inert gas allows to activate electrically the impurity simultaneously with reach of the impurity to the semiconductor substrate 12. Besides, the use of the mixed gas, for which the mixing ratio of the dopant impurity gas and inert gas has been adjusted, allows adjusting the quantity of impurity activated electrically.

In the case where the inert gas is irradiated on the surface of the semiconductor substrate 12 after the dopant impurity is adhered to the surface of the semiconductor substrate 12, the following problem occurs. Since there is fear of scattering of the adhered impurity by irradiating the inert gas, it results in difficulty of adjusting the introducing amount of the impurity.

### (Example)

Examples of the invention will be described below with reference to drawings.

First, the possibility was investigated on controlling the impurity concentration on the surface of the semiconductor substrate 12 and the depth of the impurity region of the semiconductor substrate 12 by adjusting the mixing ratio of the dopant impurity gas and an inert gas.

In the experiment, diborane gas is used as dopant impurity gas and argon gas as inert gas. Three mixing ratios were used for the diborane and the argon. In other words, the argon is added to the diborane to make the proportions of the diborane in the mixing gas 10 ppm, 100 ppm, and 1000 ppm.

Mirror finish single crystal wafer of n-type silicon with a diameter of 150 mm and a resistivity of 10 - 20 Ω · cm was used as the semiconductor substrate 12.

A direct current voltage of 600 V was applied between the electrodes 3 and 4 for discharge under the conditions that the space between the electrodes 3 and 4 was 50 mm, a pressure in electric charge was 2.66 x 10² Pa, and the discharging condition was maintained for 1 - 3 minutes.

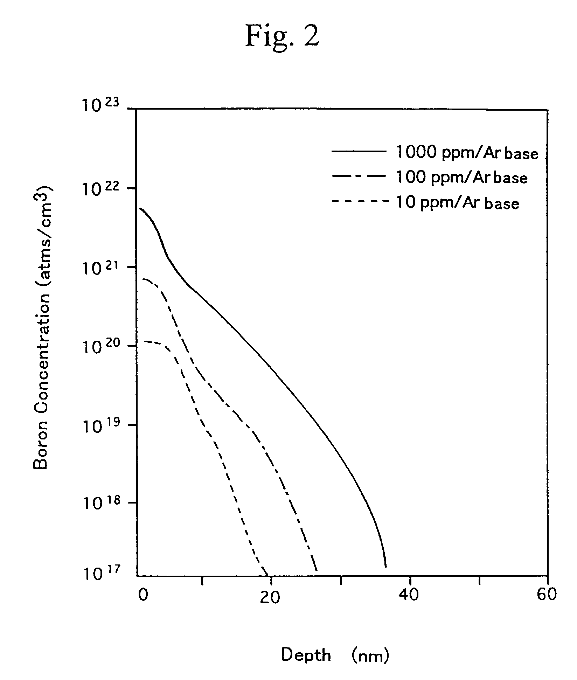

Fig. 2 is a graph showing the distribution of boron concentration in a silicon wafer, when a semiconductor region, in which silicon wafer contains boron, was formed. The vertical axis represents the concentration of boron and the horizontal axis of abscissa represents the depth from the surface of the silicon wafer.

The distribution of boron concentration was measured by SIMS (secondary ion mass spectrometer). The principle of measurement by using SIMS is as follows.

A focused ion beam is irradiated to a sample to allow secondary ions to emit from the sample and they are introduced to the mass spectrometer. The secondary ions are detected based on the ratios of electric charge to a mass to identify the species name of the ions. According to this method, not only electrically active impurities diffused in the semiconductor substrate, but also electrically inactive impurities are all detected.

From the result as shown in the Fig. 2, the inventor found that the surface concentration of boron was in a range of 10²⁰ - 10²² atms/ cm². In addition, the inventor found that the introducing depth of boron in the silicon wafer became as shallow as approximate 40 nm or shallower (within not deeper than 1 µm).

Further, the inventor found that the higher the surface concentration of diborane prepared by dilution with Ar became, the higher the surface concentration of diborane became. This means that adjustment of the dilution concentration of diborane with Ar allows regulating the surface concentration of and the penetrating depth of boron.

Next, it was examined whether boron has been introduced into the silicon wafer evenly or not.

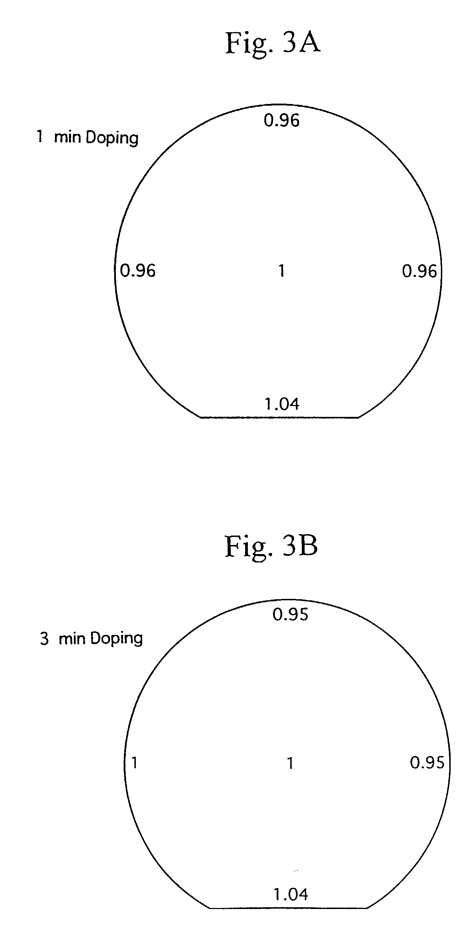

Figs. 3A and 3B are figures showing the result of measurement of a sheet resistance in the silicon wafer. Figs. 3A and 3B show the results of measurements of the sheet resistance in 1 minute and 3 minutes of discharge time respectively.

The sheet resistance was measured by using 4 point probe method after determination of 5 measuring points on the silicon wafer.

The method comprises steps of, arranging 4 probes in line at equal spaces, equally pressing the same probes to the surface of the semiconductor substrate with an equal pressure, conducting a current between two outermost probes, then conducting the current to the semiconductor substrate, measuring a voltage generated between two inner proves, and calculating a sheet resistance on the basis of this voltage.

Further, the concentration. of impurity is calculated from the sheet resistance as described below. First, the thickness of the impurity region is separately measured, and the resistivity is calculated on the basis of the thickness and the sheet resistance. Subsequently, the concentration of dopant impurity electrically activated in the semiconductor is calculated from the resistivity.

The numerical values given in the Figs. 3A and 3B represent ratios of the sheet resistance value in other measuring points, when the sheet resistance in the measuring point in the center of the silicon wafer is assumed 1.

According to the Figs. 3A and 3B, dispersion of the sheet resistance value in the surface of the silicon wafer is distributed within approximate 0.05% or smaller to suggest evenly doped boron.

Two points of view are considered as the main reasons.

As shown by an arrow in the bottom of the electrode 3 in the Fig. 1, the first point is to generate a uniform plasma condition between the electrodes 3 and 4 by the uniform flow of diborane. The secondary point is, by simultaneously irradiating boron and Ar, to realize almost simultaneously adhering of boron to the surface of the silicon wafer and activation of boron.

For reference, the rotation of the electrode improves uniformity of the distribution of sheet resistance of the surface of the silicon wafer.

In the impurity region formed with dopant gas of a 1000 ppm dilution concentration, the impurity concentration of approximate 5 x 10¹⁹ atms/ cm³ was yielded. This value yielded at a low temperature of approximate 100°C in this embodiment is almost equal to that yielded by heating at 950°C for 10 seconds in lamp annealing method. As such, a considerable decrease in temperature is possible according to the present embodiment.

Besides, though the temperature for heating the semiconductor substrate with the heater is approximate 100°C as described above, it is not limited to this. A lower temperature than that using in the prior art can be preferably selected depending on a material of a semiconductor substrate or an insulating film and an interconnection layer on the substrate.

Furthermore, practical quality of prevention to be considered no problem was examined for adhered quantity of a metal element discharged from the vacuum chamber to the silicon wafer.

Table 1 is a figure showing the quantity of metal elements adhered to the silicon wafer.

**Table 1**

| (Unit: 10¹⁰atms/cm²) | | | | | | | | | | | |
|---|---|---|---|---|---|---|---|---|---|---|---|
| Sample | | | Na | Al | Ti | Cr | Fe | Ni | Cu | Zn | W |
| Plasma | Elect. *1 | Time | | | | | | | | | |
| B₂H₆ | Al | 1min. | 1.8 | <1 | <0.3 | <0.1 | <2 | <0.4 | <0.05 | <0.1 | <0.008 |
| | | 5min. | 3.9 | 6 | <0.3 | <0.1 | <2 | <0.4 | 1.06 | 3.4 | <0.008 |
| | SUS | 1min. | 3.3 | <1 | <0.3 | <0.1 | <2 | <0.4 | <0.05 | <0.1 | <0.008 |
| | | 5min. | 5.3 | 4 | <0.3 | <0.1 | <2 | <0.4 | 0.18 | 0.6 | <0.008 |
| Ar | Al | 1min. | 2.4 | <1 | <0.3 | <0.1 | <2 | <0.4 | <0.05 | 1.3 | <0.008 |
| N₂ | Al | 5min. | 2.8 | <1 | <0.3 | <0.1 | <2 | <0.4 | <0.05 | 0.8 | <0.008 |
| carrying only | | | 2.7 | 6 | <0.3 | <0.1 | <2 | <0.4 | <0.05 | <0.1 | <0.008 |

| | | | | | | | | | | | |
|---|---|---|---|---|---|---|---|---|---|---|---|
| *1;electrode | | | | | | | | | | | |

In this experiment, quantity of metals adhered to the silicon wafer was measured in the case of separate plasma discharge of B₂H₆, Ar, and N₂ in a vacuum chamber 1 and also in the case of "carrying only". The "carrying only" means simply that a silicon wafer was introduced in the vacuum chamber 1 and then removed from the chamber without generating any plasma.

It was found that the separate plasma discharge of B₂H₆, Ar, and N₂ in a vacuum chamber 1 did not yield an extremely large quantity of metal elements, etc. adhered to the silicon wafer in comparison with "carrying only."

From the result, metal elements from the vacuum chamber 1, etc. adhere very little to the silicon wafer to allow practically a conclusion of no problem.

Therefore, it can be considered that even when discharging the mixture of inert gas and impurity gas as the present invention, the penetration of particles other than the impurity gas to the semiconductor substrate 12 can be restricted.

As described so far in the present example, since the semiconductor substrate is not heated to a high temperature, penetration of particles other than the dopant impurity to the semiconductor substrate is prevented and the depth of the impurity region not deeper than 1 µm can be realized.

In addition, the use of the mixing gas of inert gas and dopant impurity gas allows making the concentration of impurity of the surface of the semiconductor substrate uniform.

Furthermore, the change of the mixing ratio of dopant impurity gas and inert gas allows regulating the mixture gas to a proper concentration of 10²² atms/ m³ or lower.

As described above, according to the present invention, no require of heating the semiconductor layer at a high temperature can decrease crystal defect, etc, and can prevent deep penetration of impurities to the semiconductor layer.

Furthermore, the plasma treatment of a mixing gas of an impurity gas and any one of H₂ and an inert gas allows to simultaneously cause activation of the impurity as well as adherence of the impurity to the surface of the semiconductor layer.

Moreover, the use of a mixing gas prepared by adjusting the mixing ratio of the impurity gas with the gas containing any one of H₂ and inert gases allows adjusting the introducing amount of impurity.

Besides, in the embodiment of the present invention, although the parallel plate electrodes are used as the discharging means, it is not limited to this. For example, electron cyclotron resonance (ECR) may be also used.

## Claims

1. A method for formation of impurity region in a semiconductor layer comprising the steps of:
mixing an impurity gas with a gas containing any one of H₂ and inert gases;
electrically discharging simultaneously at least said impurity gas and any one of H₂ and inert gases of said mixed gas;
diffusing impurities adhered to the surface of the semiconductor layer (12) in the semiconductor layer (12) by introducing the discharged impurity gas to the surface of the semiconductor layer (12), at the same time, by accelerating ions of the gas containing any one of the H₂ and inert gases to irradiate on the surface of the semiconductor layer (12), and by raising temperature of the surface of the semiconductor layer (12); and
at the same time, electrically activating the impurities.

2. A method -for formation of impurity region in a semiconductor layer according to claim 1, wherein in said step of electrically discharging simultaneously at least said impurity gas inert gas and any one of H₂ and inert gases of said mixed gas, said discharging allows to be occurred by applying a direct current voltage to said mixed gas.

3. A method for formation of impurity region in a semiconductor layer according to claim 1, wherein in said step of diffusing impurities in the semiconductor layer and electrically activating the impurities, said semiconductor layer is heated by heating means (13).

4. A method for formation of impurity region in a semiconductor layer according to claim 1, wherein the inert gas is any one of Ar and N₂.

5. A method for formation of impurity region in a semiconductor layer according to claim 1, wherein said impurity gas contains an impurity element of any one of boron, phosphorus, aluminum, arsenic, and gallium.

6. A method for formation of impurity region in a semiconductor layer according to claim 5, wherein said impurity gas is any one of hydrogen compound gas containing the impurity element, halogenated compound gas containing the impurity element, and organic metals gas containing the impurity element.

7. An apparatus for introducing an impurity to a semiconductor layer comprising:
a regulating means (10) for regulating mixing ratio of an impurity gas with a gas containing any one of H₂ and inert gases;
an electrically discharging means (3,4,5) for discharging the impurity gas sent from said regulating means and a gas containing any one of the H₂ and inert gases;
an accelerating means (3,4,5) for accelerating ions of a gas containing any one of the H₂ and inert gases; and
wherein by introducing the discharged impurity gas to the surface of the semiconductor layer (12), at the same time, by accelerating ions of the gas containing any one of the H₂ and inert gases to irradiate the surface of the semiconductor layer (12), and by raising temperature of the surface of the semiconductor layer (12), impurities adhered to the surface of the semiconductor layer are diffused in the semiconductor while electrically activating the impurities.

8. An apparatus for introducing an impurity to a semiconductor layer according to claim 7, wherein said electrically discharging means is a means for discharging electrically by an electric field between parallel plate electrodes (3,4).

9. An apparatus for introducing an impurity to a semiconductor layer according to claim 7, wherein said electrically discharging means is a means for generating electrical discharge by electron cyclotron resonance.

10. An apparatus for introducing an impurity to a semiconductor layer according to claim 8, wherein said electrically discharging means has a power source (5) connected to the parallel plate electrodes (3,4) and the power source (5) can generate a direct current voltage.

11. An apparatus for introducing an impurity to a semiconductor layer according to claim 8, wherein said electrically discharging means has a power source (5) connected to the parallel plate electrodes (3,4) and the power source (5) can generate a direct current voltage and a pulse-like voltage having a polarity opposite to the polarity of the direct current voltage.

12. An apparatus for introducing an impurity to a semiconductor layer according to claim 7, further comprising heating means (13) for heating the semiconductor substrate.

13. An apparatus for introducing an impurity to a semiconductor layer according to claim 7, wherein the inert gas is any one of Ar and N₂.

14. An apparatus for introducing an impurity in a semiconductor layer according to claim 7, wherein the impurity gas contains an impurity element of any one of boron, phosphorus, aluminum, arsenic, and gallium.

15. An apparatus for introducing an impurity in a semiconductor layer according to claim 14, wherein the impurity gas is any one of gases of hydrogen compounds containing the impurity element, halogenated compounds containing the impurity element, and organic metals containing the impurity element.
